(19) Europäisches Patentamt
European Patent Office
Office européen des brevets

(11) EP 2 175 495 B1

(12) **EUROPEAN PATENT SPECIFICATION**

(45) Date of publication and mention of the grant of the patent:
**26.06.2013 Bulletin 2013/26**

(51) Int Cl.:
***H01L 31/0216*** *(2006.01)* ***H01L 31/048*** *(2006.01)*
***H01L 21/77*** *(2006.01)* ***H01L 29/786*** *(2006.01)*

(21) Application number: **09172766.9**

(22) Date of filing: **12.10.2009**

(54) **Sealed device**

Abgedichtete Vorrichtung

Dispositif étanche

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **10.10.2008 JP 2008263705**

(43) Date of publication of application:
**14.04.2010 Bulletin 2010/15**

(73) Proprietor: **Fujifilm Corporation**
**Minato-ku**
**Tokyo 106-0031 (JP)**

(72) Inventor: **Tsukahara, Jiro**
**Kanagawa 258-8577 (JP)**

(74) Representative: **HOFFMANN EITLE**
**Patent- und Rechtsanwälte**
**Arabellastrasse 4**
**81925 München (DE)**

(56) References cited:
**EP-A1- 1 763 086**
**WO-A1-2006/110048**
**US-A1- 2007 052 025**
**US-B1- 6 501 014**

EP 2 175 495 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

## Description

### TECHNICAL FIELD

The present invention relates to a sealed device comprising, as the constitutive element, a semiconductor layer containing zinc and oxygen, or an electroconductive layer containing zinc and oxygen.

### BACKGROUND ART

Heretofore, it is investigated to provide a gas-barrier laminate film or a protective film over a device that may be readily deteriorated by water vapor or oxygen in air. USP 6,268, 695, US 2007/052025 A1 and US 6501014 B1 describe sealed devices produced by sealing up the surface of a device provided on a substrate, with an organic-inorganic laminate. JP-A 2007-184251, WO 2006/110048 A1 and EP 1 763 086 A1 describes disposition of a protective layer (passivation layer) on the surface of a light-emitting device, silicon based wafer and photovoltaic cell, respectively, provided on a substrate. In this, the protective layer is a silicon hydronitride layer.

Recently, various semiconductor materials containing zinc and oxygen, and various electroconductive materials containing zinc and oxygen have been put into practical use. These materials are readily deteriorated by moisture (e.g., water vapor), and therefore a sealing technique for protecting them from moisture penetration thereinto and a moisture-absorbing technique of absorbing moisture having penetrated into them are real problems in their practical use. In a conventional sealing technique of sealing up a device by the use of a stainless can or a glass can (so-called can-sealing), a desiccant such as calcium oxide or the like is put into the free space inside the can to thereby solve the two problems of sealing and moisture absorption. However, in a method of sticking a glass plate or a gas-barrier laminate film directly to a device (so-called solid-sealing) or in a method of disposing a gas-barrier film directly over a device (so-called film-sealing), a desiccant could not be put into it since the sealed device does not have a free space. In this case, there is a problem in that the sealed device may be deteriorated by the moisture originally existing inside the device or by the moisture having penetrated into the device not via the sealing material (for example, the water vapor having penetrated thereinto via the edge face of the device or the adhesive applied to the device). The deterioration by moisture shortens the life of the device.

### SUMMARY OF THE INVENTION

Having an object to solve these problems, the present invention is to provide a technique of protecting a device that comprises, as the constitutive element, a semiconductor layer containing zinc and oxygen, or an electroconductive layer containing zinc and oxygen, from deterioration by water vapor.

Given the situation, the present inventors have assiduously studied and surprisingly have found that, when a device provided on a substrate is sealed up with a barrier laminate containing a silicon hydronitride layer, then the device can be protected from deterioration by moisture, the laminate serves substantially as a desiccant and can therefore bring about a remarkable effect.

The invention provides the following:

(1) A sealed device having in that order:

a substrate,
a device having a semiconducting or an electroconductive layer comprising zinc and oxygen, a silicon hydronitride layer; and
a gas-barrier laminate comprising an organic layer or region, and an inorganic layer or region.

(2) The sealed device of (1), wherein the device on the substrate is sealed with the silicon hydronitride layer.
(3) The sealed device of (2), wherein the device is further sealed with the gas-barrier laminate.
(4) The sealed device of any one of (1) to (3), wherein the silicon hydronitride layer comprises oxygen atom in an amount of at most 50% by atom relative to nitrogen atom in the silicon hydronitride layer.
(5) The sealed device of any one of (1) to (4), wherein the silicon hydronitride layer has a hydrogen/nitrogen atomic ratio of from 0.1 to 3.
(6) The sealed device of any one of (1) to (5), wherein the silicon hydronitride layer has a density of from 1.8 to 2.7 g/$m^3$.
(7) The sealed device of any one of (1) to (6), wherein the semiconductor layer or the electroconductive layer comprises zinc oxide.
(8) The sealed device of any one of (1) to (7), wherein the gas-barrier laminate comprises at least two organic layers and at least two inorganic layers that are alternately laminated.

(9) The sealed device of any one of (1) to (8), wherein the substrate is a flexible substrate.

(10) The sealed device of any one of (1) to (9), wherein the inorganic region or the inorganic layer comprises aluminium oxide.

(11) The sealed device of any one of (1) to (9), wherein the inorganic region or the inorganic layer comprises silicon oxide.

(12) The sealed device of any one of (1) to (11), wherein the organic region or the organic layer comprises an acrylate polymer.

(13) The sealed device of any one of (1) to (12), wherein the device is a solar cell.

(14) The sealed device of any one of (1) to (12), wherein the device is a thin-film transistor.

The invention has made it possible to protect a device comprising, as the constitutive element, a semiconductor layer containing zinc and oxygen or an electroconductive layer containing zinc and oxygen, especially such a solid-sealed or film-sealed device not having a free space on the device, from deterioration by water vapor and to prolong the life of the device.

BRIEF DESCRIPTION OF THE DRAWINGS

Fig. 1 is a schematic view showing an example of an environment-sensitive device.

Fig. 2 is a schematic view showing an example of a more concrete constitution of an environment-sensitive device of the invention.

Fig. 3 is a schematic view showing another example of an environment-sensitive device.

Fig. 4 is a schematic cross-sectional view of a thin-film transistor produced in Examples of the invention.

In these drawings, 1 is a substrate; 2 is an environment-sensitive device; 3 is a gas-barrier laminate; 301 is a passivation layer; 302 is a silicon hydronitride layer; 303 is an organic-inorganic laminate; 311 is a passivation layer; 313 is an organic-inorganic laminate; 41 is a substrate; 42 is a gate electrode; 43 is a gate-insulating film; 44 is an active layer.

DETAILED DESCRIPTION OF THE INVENTION

The contents of the invention are described in detail hereinunder. In this description, the numerical range expressed by the wording "a number to another number" means the range that falls between the former number indicating the lowermost limit of the range and the latter number indicating the uppermost limit thereof.

<Sealed Device>

The sealed device of the invention is a device comprising a semiconductor layer or an electroconductive layer containing zinc and oxygen, as provided on a support, and is **characterized in that** the device is sealed up with a barrier laminate. which has a silicon hydronitride region. The silicon hydronitride region has the ability to absorb moisture and is therefore effective for prolonging the life of the device.

A sealed device is described below with reference to Fig. 1. In Fig. 1, 1 is a substrate, 2 is a device, and 3 is a gas-barrier laminate having a silicon hydronitride layer. Any other layer and substrate may be further laminated on 3.

The device as referred to herein is, for example, meant to indicate a part that comprises a pair of electrodes and a layer disposed between them in a solar cell, and the part controls the substantial function of the device. The device 2 is generally disposed on the substrate 1 (the constitution of the device 2 as combined with the substrate 1 may be referred to as a device).

The gas-barrier laminate 3 in this embodiment comprises at least one silicon hydronitride region, at least one inorganic region and at least one organic region. The term "region" as referred to herein may be generally read as a layer, further including a graded material not having any definite interface between the constitutive layers.

Fig. 2 is to show concretely the sealed device of the invention. In the drawing, 301 is an inorganic layer (so-called passivation layer); 302 is a silicon hydronitride layer; and 303 is an organic-inorganic laminate. The organic-inorganic laminate comprises at least one organic layer and at least one inorganic layer. Plural organic layers and inorganic layers may be laminated alternately. The laminate may have an organic layer or an inorganic layer on the side thereof facing the underlying layer 302; and the laminate may have an organic layer or an inorganic layer on the side thereof facing outside (interface to the environment). Preferably, in the invention, at least two organic layers and at least two inorganic layers constitute the laminate.

Fig. 3 is another specific example of a sealed device of the invention. In the drawing, 311 is an inorganic layer (so-called passivation layer), and 313 is an organic-inorganic laminate. The organic-inorganic laminate comprises at least one silicon hydronitride layer, at least one organic layer and at least one inorganic layer. Aplurality of these constitutive layers may be laminated. Of the laminate, any of a silicon hydronitride layer, an organic layer and an inorganic layer may face the underlying layer 311. Also any of a silicon hydronitride layer, an organic layer and an inorganic layer of the laminate may face the outside (interface to the environment); however, in case where the laminate 313 is not coated with any other layer, the function of moisture absorbability of the silicon hydronitride layer may be worsened owing to its contact with the external environment, and therefore, at least one inorganic layer is present between the silicon hydronitride layer and the external environment. Fig. 2 and Fig. 3 are to show examples of the invention, and the constitution of the sealed device of the invention should not be limited to these.

<Substrate>

As the substrate for the sealed device of the invention, various substrates (glass, stainless, plastic film, etc.) are broadly employable. The substrate may be a flexible substrate, and preferred are flexible metal substrates, flexible alloy substrates and plastic substrates with an insulating layer disposed thereon. The flexible metal substrates are preferably those comprising stainless, chromium, aluminium or the like. The plastic films include those of thermoplastic resin such as polyester resin, methacrylic resin, methacrylic acid-maleic acid copolymer, polystyrene resin, transparent fluororesin, polyimide resin, fluoropolyimide resin, polyamide resin, polyamidimide resin, polyetherimide resin, cellulose acylate resin, polyurethane resin, polyether-ether-ketone resin, polycarbonate resin, alicyclic polyolefin resin, polyarylate resin, polyether-sulfone resin, polysulfone resin, cycloolefin copolymer, fluorene ring-modified polycarbonate resin, alicyclic-modified polycarbonate resin, fluorene ring-modified polyester resin, acryloyl compound, etc. Preferably, the plastic films have a gas-barrier property. Preferred examples of the films having a gas-barrier property include those having an organic layer or an inorganic layer provided thereon, as well as gas-barrier films described in JP-A 2004-136466, 2004-148566, 2005-246716, 2005-262529.

<Device>

The device of the invention comprises, as the constitutive element thereof, a semiconductor layer containing zinc and oxygen, or an electroconductive layer containing zinc and oxygen. The semiconductor layer containing zinc and oxygen is a layer comprising a semiconductor material containing zinc and oxygen; and the electroconductive layer containing zinc and oxygen is a layer comprising an electroconductive material containing zinc and oxygen. The semiconductor material containing zinc and oxygen includes zinc oxide and impurity-doped zinc oxide. The electroconductive material containing zinc and oxygen includes impurity-doped zinc oxide. In the impurity-doped zinc oxide, the carrier concentration may be changed depending on the type of the impurity and the dopant dose, and the impurity-doped zinc oxide may continuously change from a semiconductor to an electroconductor. The dopant is typically a Group 13 element, and its preferred examples include boron, aluminium, gallium, indium. In addition, the dopant may also be a Group 12 element (e.g., cadmium) or a Group 16 element (e.g., sulfur, selenium). One or more such dopants may be employed herein for doping. The electroconductive layer or the semiconductor layer may be formed of one type of a material, but may have a multi-layer structure formed of two or more different types of materials. The layer may also be a graded material layer where the composition changes continuously.

Specific examples of impurity-doped zinc oxide include ZnO:B, ZnO:Al, ZnO:In, ZnO:Ga, ZnO:(In,Ga). The expression ZnO:B means zinc oxide doped with boron as an impurity. The expression ZnO: (In,Ga) means zinc oxide doped with indium and gallium as impurities. ZnO:(In,Ga) may be abbreviated as IGZO.

The device in the invention includes a solar cell, a thin-film transistor, etc. The present inventors' studies have revealed that, when these devices are exposed to air containing water vapor for a long period of time, then their properties are worsened. This may be because the semiconductor material and the electroconductive material containing zinc and oxygen have the property of slightly dissolving in water.

(CIGS Solar Cell)

One example of the solar cell is a CIGS solar cell. The CIGS solar cell is a generic term for solar cells comprising a chalcopyrite compound semiconductor as a photoelectric conversion material; and this includes, for example, a copper/indium/selenium (CIS) solar cell, a copper/indium/gallium/selenium (CIGS) solar cell, and a copper/indium/gallium/selenium/sulfur (CIGSS) solar cell. The CIGS solar cell comprises at least a positive electrode, a photoelectric conversion layer, an n-type semiconductor layer, and a negative electrode.

As the positive electrode, a material comprising a Group 6 element of the Periodic Table is used. Concretely usable are metals such as chromium, molybdenum, tungsten; and molybdenum compounds (e.g., $MoSe_2$). Of those,

preferred is a metal molybdenum.

The photoelectric conversion layer is a p-type semiconductor layer. In the invention, the photoelectric conversion layer is a thin film of a chalcopyrite structure compound comprising a Group 11 element, a Group 13 element and a Group 16 element. As the Group 11 element, preferred is Cu. As the Group 13 element, preferred are aluminium, gallium, indium and their mixtures. As the Group 16 element, preferred are sulfur, selenium and tellurium. Specific examples of the semiconductor compounds include $CuGaS_2$, $CuGaSe_2$, $CuInS_2$, $CuInSe_2$(CIS), Cu(In,Ga)$S_2$, Cu(In,Ga)$Se_2$(CIGS), Cu(In,Ga)(S,Se)$_2$, etc. Of those, preferred are CIS and CIGS; and more preferred is CIGS. In the above description, (In, Ga) and (S, Se) each mean ($In_{1-x}Ga_x$) and ($S_{1-y}Se_y$), respectively (where x = 0 to 1, and y = 0 to 1). The thickness of the photoelectric conversion layer may be generally from 100 nm to 5 μm.

The n-type semiconductor layer is a thin film of a Group II-VI compound semiconductor that forms a good junction to the photoelectric conversion layer. Preferred examples of the material include, for example, CdS, CdSe, ZnO, ZnS, Zn(O,S,OH), ZnMgO, etc. The thickness of the n-type semiconductor layer may be generally from 10 nm to 500 nm.

A transparent electroconductive material is used for the negative electrode. The transparent electroconductive material may be any known material including $In_2O_3$:Sn(ITO), ZnO:Ga, ZnO:Al, ZnO:B, $SnO_2$:F, etc. The thickness of the negative electrode may be generally from 100 nm to 5 μm. An additional metal electrode may be combined with the negative electrode for power collection. For use herein, the metal electrode is patterned so as not to reduce the aperture of the solar cell.

(Thin-Film Transistor)

Another example of the device of the invention is a thin-film transistor comprising IGZO. The thin-film transistor is an active device comprising at least a gate electrode, a gate-insulating film, an active layer, a source electrode and a drain electrode in that order, in which a voltage is applied to the gate electrode to control the current running through the active layer and the current between the source electrode and the drain electrode is switched. The TFT structure may be any of a staggered structure or a reversed-staggered structure.

For the gate-insulating film, employed is an insulating material such as $SiO_2$, $SiN_x$, SiON, $Al_2O_3$, $Y_2O_3$, $Ta_2O_5$, $HfO_2$, etc.; or a mixed crystal compound containing at least two of those compounds. A polymer insulating material such as polyimide is also usable for the gate-insulating film.

The thickness of the gate-insulating film is preferably from 10 nm to 10 μm. The gate-insulating film must be thick in some degree for reducing the leak current and for increasing the withstand voltage. However, when the thickness of the gate-insulating film is increased, then the driving voltage for TFT will have to be increased. Accordingly, more preferably, the thickness of the gate-insulating film is from 50 nm to 1 μm when the film is formed of an inorganic insulating material, or is from 500 nm to 5 μm when the film is formed of a polymer insulating material. In particular, a high-dielectric insulating material such as $HfO_2$ is especially favorable for the gate-insulating film, as enabling low-voltage TFT driving even though the film is thick.

As the active layer, preferred is a Zn-containing oxide semiconductor. More preferred is an amorphous oxide semiconductor. The oxide semiconductor, especially an amorphous oxide semiconductor can form a film at a low temperature, and therefore it may form a film on a flexible resin substrate such as plastics. The amorphous oxide semiconductor capable of forming a film at a low temperature includes oxides containing In and Zn and oxides containing In Ga and Zn as in JP-A 2006-165529; and regarding the composition structure thereof, it is known that $InGaO_3(ZnO)_m$ (m is a natural number less than 6) is preferred. These are n-type semiconductors where the carrier is an electron. Needless-to-say, p-type oxide semiconductors such as $ZnO{\cdot}Rh_2O_3$ are also usable for the active layer and the resistance layer. The thickness of the active layer is preferably from 1 nm to 500 nm.

For the gate electrode in the invention, for example, preferred are metals such as Al, Mo, Cr, Ta, Ti, Au, Ag, etc.; alloys such as Al-Nd, APC, etc.; metal oxide electroconductive films of tin oxide, zinc oxide, indium oxide, indium tin oxide (ITO), indium zinc oxide (IZO), etc.; organic electroconductive compounds such as polyaniline, polythiophene, polypyrrole, etc. ; and their mixtures. Preferably, the thickness of the gate electrode is from 10 nm to 1 μm.

As the material for the source electrode and the drain electrode in the invention, for example, there may be mentioned metals such as Al, Mo, Cr, Ta, Ti, Au, Ag, etc.; alloys such as Al-Nd, APC, etc.; metal oxide electroconductive films of tin oxide, zinc oxide, indium oxide, indium tin oxide (ITO), indium zinc oxide (IZO), etc.; organic electroconductive compounds such as polyaniline, polythiophene, polypyrrole, etc.; and their mixtures. Preferably, the thickness of the source electrode and the drain electrode is from 10 nm to 1 μm each.

(Gas-Barrier Laminate)

The gas-barrier laminate in the invention contains an inorganic layer or an inorganic region, and an organic layer and an organic region, and generally contains an inorganic layer and an organic layer. Preferably, the barrier laminate in the invention has a constitution of at least two inorganic layers and at least two organic layers that are

laminated alternately.

(Inorganic Layer or Inorganic Region)

The inorganic layer is generally a layer of a thin film of a metal compound. For forming the inorganic layer, employable is any method capable of forming the intended thin film. For example, a coating method, a sputtering method, a vacuum vapor deposition method, an ion-plating method, a plasma CVD method and the like are suitable for it; and concretely, the methods for film formation described in Japanese Patent 3400324, JP-A 2002-322561 and 2002-361774 are usable herein.
Not specifically defined, the ingredients of the inorganic layer may be any ones satisfying the above-mentioned capabilities, for which, for example, employable are oxides, nitrides, carbides, oxinitrides, oxicarbides, nitrocarbides, oxinitrocarbides and others containing at least one metal selected from Si, Al, In, Sn, Zn, Ti, Cu, Ce, Ta, etc.; and diamond-like compounds comprising C, or C and Si. Of those, preferred are oxides, nitrides and oxinitrides of a metal selected from Si, Al, In, Sn, Zn and Ti; and more preferred are oxides, nitrides or oxinitrides of Si or Al. These may contain any other element as a side component. In the invention, aluminium oxide, silicon oxide, silicon oxinitride and silicon nitride are especially preferred for the inorganic layer.
Not specifically defined, the thickness of the inorganic layer is preferably within a range of from 5 nm to 500 nm, more preferably from 10 nm to 200 nm.
The inorganic layer may be formed of one inorganic material, or may comprise a mixture of two or more different types of inorganic layers. Two or more layers of different materials may be laminated. As described in the above, the inorganic layer may not have a definite interface to the adjacent organic layer, as in USP-A 2004-46497, and may be a layer in which its composition changes continuously in the thickness direction thereof (inorganic region).

(Organic Layer or Organic Region)

Preferably, the organic layer in the invention comprises an organic polymer as the main ingredient thereof. The main ingredient as referred to herein means that the first one of the ingredients constituting the organic layer is an organic polymer, and in general, an organic polymer accounts for at least 80% by weight of the ingredients constituting the organic layer.
The organic polymer includes, for example, thermoplastic resins such as polyester, acrylic resin, methacrylic resin, methacrylic acid-maleic acid copolymer, polystyrene, transparent fluororesin, polyimide, fluoropolyimide, polyamide, polyamidimide, polyetherimide, cellulose acylate, polyurethane, polyether-ether-ketone, polycarbonate, alicyclic polyolefin, polyarylate, polyether sulfone, polysulfone, fluorene ring-modified polycarbonate, alicyclic-modified polycarbonate, fluorene ring-modified polyester, acryloyl compound, etc.; organosilicon polymers such as polysiloxane, etc. The organic layer may be formed of a single material or a mixture, or may have a laminate structure of sublayers. In this case, the constitutive sublayers may have the same composition or different compositions. As described in the above, the organic layer may not have a definite interface to the adjacent inorganic layer, as in USP-A 2004-46497, and may be a layer in which its composition changes continuously in the thickness direction thereof (organic region).
Preferably, the organic layer in the invention is formed by curing a polymerizable composition that comprises a polymerizable compound.

(Polymerizable Compound)

The polymerizable compound is preferably a radical polymerizable compound and/or a cationic polymerizable compound having an ether group in the functional group therein. More preferred are a compound having an ethylenic unsaturated bond at the terminal or in the side chain thereof, and/or a compound having an epoxy or oxetane group at the terminal or in the side chain thereof. Of these, the compound having an ethylenic unsaturated bond at the terminal or in the side chain thereof is preferred. Examples of the compound having an ethylenic unsaturated bond at the terminal or in the side chain thereof include (meth)acrylate compounds, acrylamide compounds, styrene compounds, maleic anhydrides, etc.; and preferred are (meth)acrylate compounds and/or styrene compounds, more preferred are (meth) acrylate compounds.
Preferred examples of (meth)acrylate compounds are (meth)acrylates, urethane (meth)acrylates, polyester (meth)acrylates, epoxy (meth)acrylates, etc.
Preferred examples of styrene compounds are styrene, $\alpha$ -methylstyrene, 4-methylstyrene, divinylbenzene, 4-hydroxystyrene, 4-carboxystyrene, etc.
Specific examples of the (meth)acrylate compounds preferred for use in the invention are shown below, to which, however, the invention should not be limited.

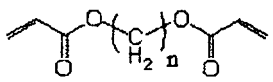

n=4,6,9,10,12,14,16

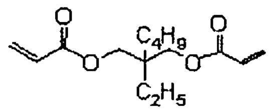

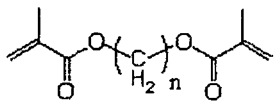

n=4,6,9,10,12,14,16

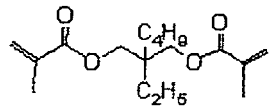

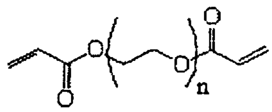

n=2,3,4,5

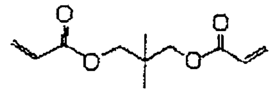

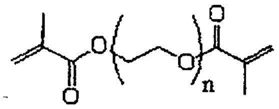

n=2,3,4,5

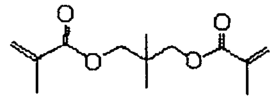

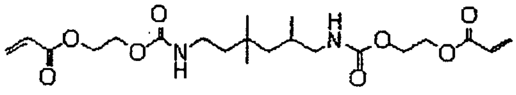

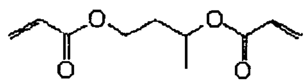

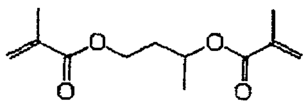

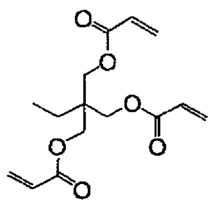

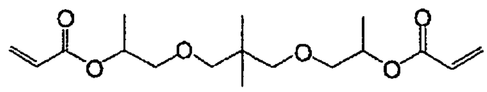

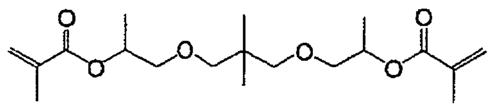

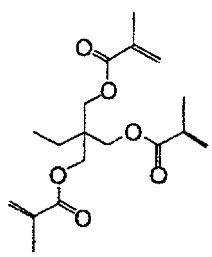

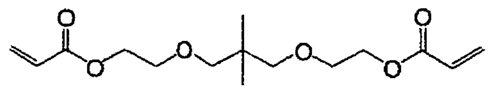

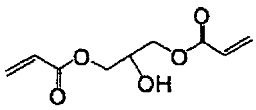

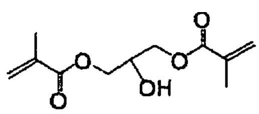

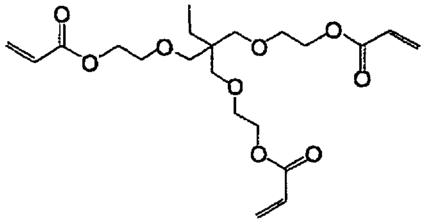

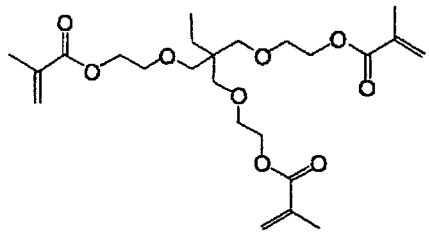

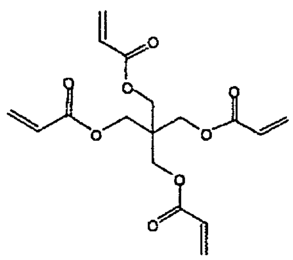

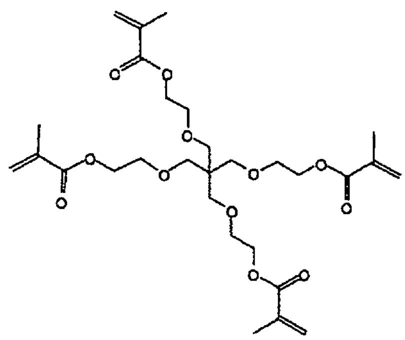

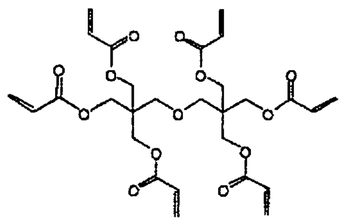

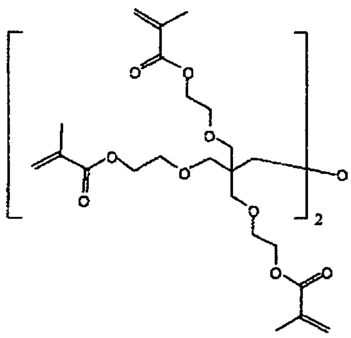

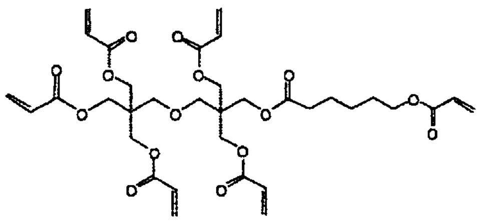

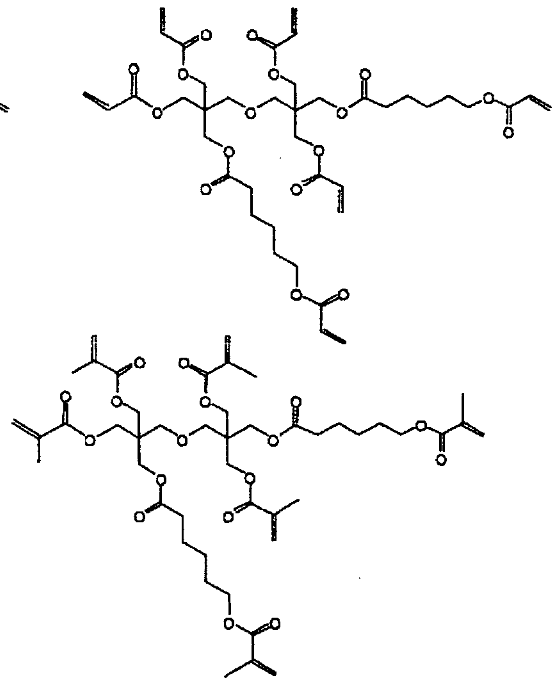

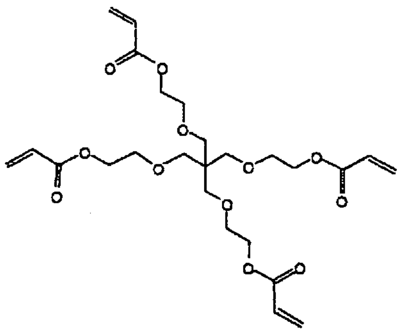

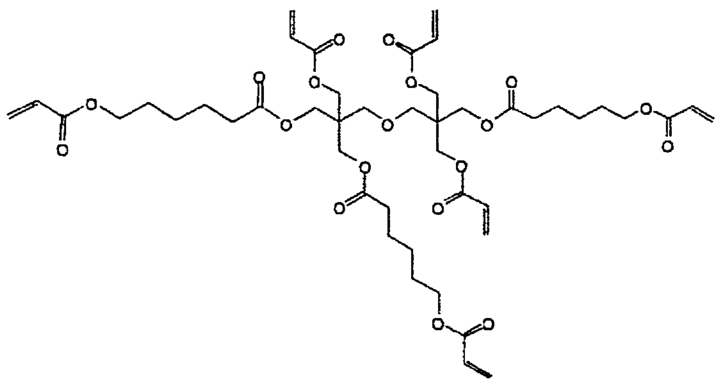

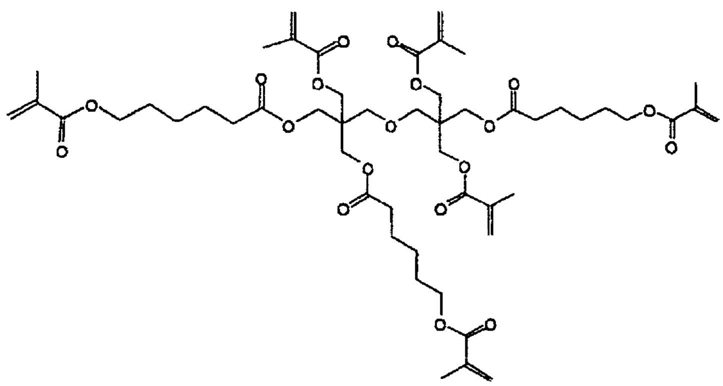

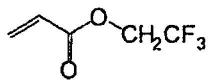
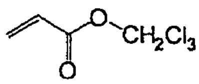

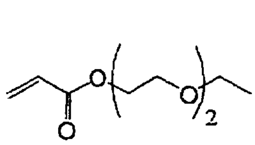
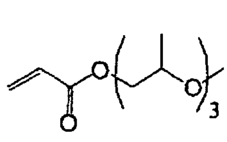
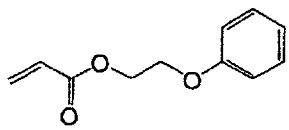

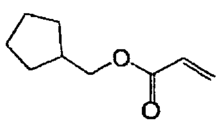
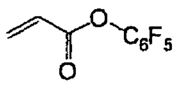
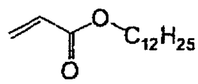

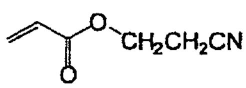
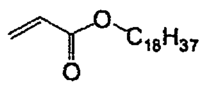
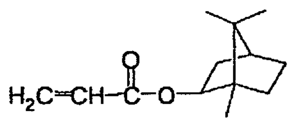

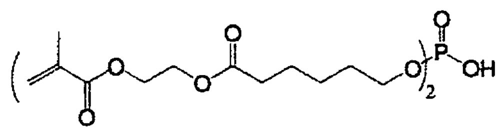
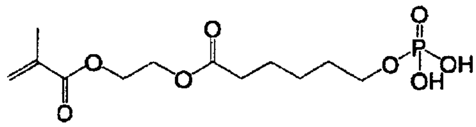

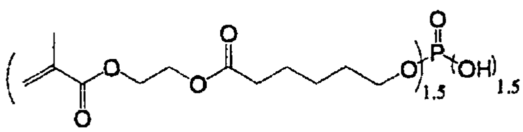
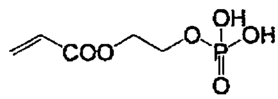

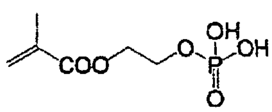
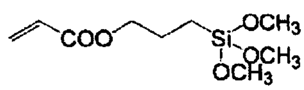
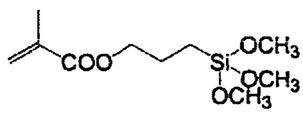

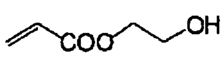
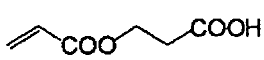
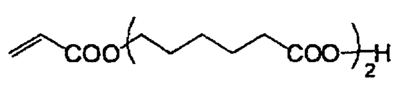

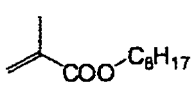
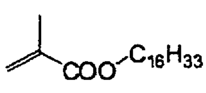
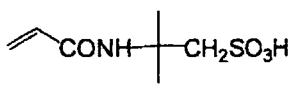

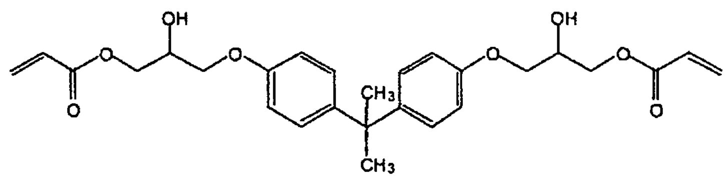

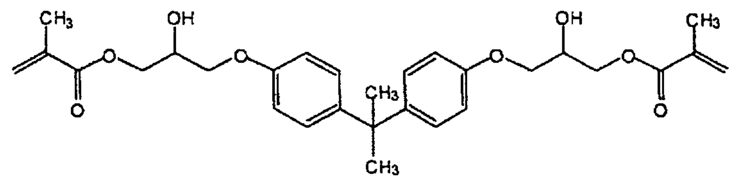

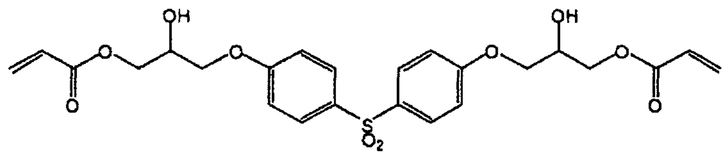

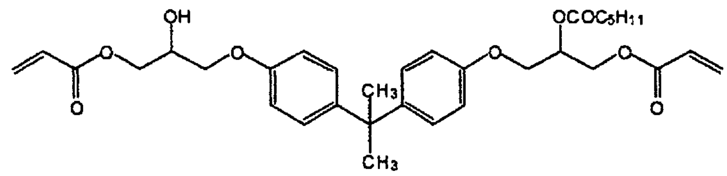

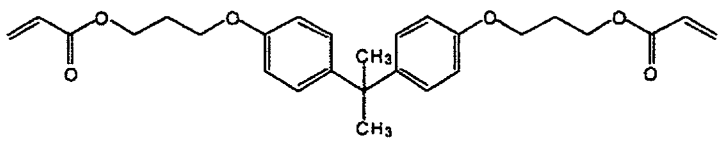

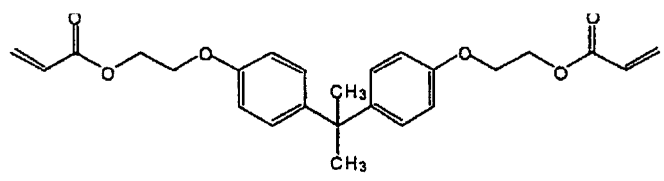

(Polymerization Initiator)

When the organic layer in the invention is formed by coating and curing a polymerizable composition comprising a polymerizable monomer, a polymerization initiator may be included in the polymerizable composition. When a photopolymerization initiator is used, its amount is preferably at least 0.1 mol% of the total amount of the polymerizable compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959, Irgacure 907, Irgacure 369, Irgacure 379, Irgacure 819), Darocure series (e.g., Darocure TPO, Darocure 1173), Quantacure PDO; Lamberti's commercial products, Esacure series (e.g., Esacure TZM, Esacure TZT, Esacure KTO46) and oligomer-type Esacure KIP series, etc.

(Method of formation of organic layer)

The method for forming the organic layer is not specifically defined. For example, the layer may be formed according to known coating methods such as a solution coating method and a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD. In the present invention, the polymer may be applied for coating as its solution, or a hybrid coating method along with an inorganic material, as in JP-A 2000-323273 and 2004-25732, may also be used.

In the present invention, the polymerizable composition is exposed to light for curing, and the light for exposure is generally a UV ray from a high-pressure mercury lamp or low-pressure mercury lamp. The radiation energy is preferably at least 0.1 J/$cm^2$, more preferably at least 0.5 J/$cm^2$. Acrylate and methacrylate may suffer from interference in polymerization owing to oxygen in air, and therefore, in their polymerization, the oxygen concentration or the oxygen partial pressure is preferably lowered. When the oxygen concentration in polymerization is lowered according to a nitrogen purging method, the oxygen concentration is preferably at most 2%, more preferably at most 0.5%. When the oxygen partial pressure in polymerization is lowered by a pressure reduction method, the whole pressure is preferably at most 1000 Pa, more preferably at most 100 Pa. Especially preferable is UV polymerization with at least 0.5 J/$cm^2$ energy radiation under a condition of reduced pressure of at most 100 Pa.

The organic layer is preferably smooth and having a hard surface. The mean surface roughness (Ra) in 1 $\mu m^2$ of the organic layer is preferably less than 1 nm, more preferably less than 0.5 nm. Preferably, the rate of polymerization of monomer is at least 85%, more preferably at least 88%, even more preferably at least 90%, still more preferably at least 92%. The rate of polymerization as referred to herein means the ratio of the reacted polymerizable group to all the polymerizable group (acryloyl group and methacryloyl group) in the monomer mixture. The rate of polymerization may be quantitatively determined according to IR absorptiometry.

The thickness of the organic layer is not specifically defined. However, when the layer is too thin, then its thickness could hardly keep uniformity; but when too thick, the layer may be cracked by external force applied thereto and its barrier-property may lower. From these viewpoints, the thickness of the organic layer is preferably from 50 nm to 2000 nm, more preferably from 200 nm to 1500 nm.

As so mentioned in the above, the organic layer is preferably smooth. The surface of the organic layer is required not to have impurities and projections such as particles. Accordingly, it is desirable that the organic layer is formed in a clean room. The degree of cleanness is preferably at most class 10000, more preferably at most class 1000.

Preferably, the hardness of the organic layer is higher. It is known that, when the hardness of the organic layer is high, then the inorganic layer may be formed smoothly and, as a result, the barrier level of the gas barrier film is thereby improved. The hardness of the organic layer may be expressed as a microhardness based on a nano-indentation method. The microhardness of the organic layer is preferably at least 100 N/mm, more preferably at least 150 N/mm.

(Lamination of Organic Layer and Inorganic Layer)

The organic layer and the inorganic layer may be laminated by repeated film formation to form the organic layer and the inorganic layer in a desired layer constitution. Particularly, the barrier laminate of the present invention shows improved barrier property when it has an alternately laminated structure of at least two organic layers and at least two inorganic layers. The alternative laminate may be that an organic layer / an inorganic layer / an organic layer / an inorganic layer are laminated on a device side (silicon hydronitride layer side) in this order, or that an inorganic layer / an organic layer / an inorganic layer / an organic layer are laminated on a device side in this order.

A plastic film may be disposed on the side opposite to the barrier laminate of the device. To attain the constitution, a device may be sealed up with a plastic film having a barrier laminate. Alternatively, a laminate of a device and a silicon hydronitride layer may be stuck to a plastic film having an organic-inorganic laminate, thereby sealing up the device. Any adhesive may be used with no specific limitation, including, for example, commercially-available thermosetting adhesive, UV-curable adhesive, etc.

(Silicon Hydronitride Layer)

The "silicon hydronitride layer" in the invention is a layer comprising silicon hydronitride as the main ingredient thereof, and for example, silicon hydronitride accounts for at least 90% by weight of the layer. Silicon hydronitride may contain an oxygen atom. However, when the oxygen content of the compound is too large, then the moisture absorbability (deoxidizability) of the layer may lower; and therefore, the amount of oxygen that may be in the layer is preferably at most 50% by atom of nitrogen in the silicon hydronitride layer.

Silicon hydronitride has moisture absorbability. When the hydrogen content of the compound is low, then the moisture absorbability thereof may lower; but on the contrary, when the hydrogen content is too high, then the material may be poorly stable. Accordingly, in the invention, the hydrogen/nitrogen ratio (by atomic number) in the silicon hydronitride layer may be from 0.1 to 3, preferably from 0.2 to 2. Silicon hydronitride may be produced according to a plasma-enforced chemical vapor deposition (PECVD) method. As the starting gas, a mixed gas of ammonia and silane may be used, and if desired, nitrogen and hydrogen may be mixed with it. For increasing the hydrogen content of the compound silicon hydronitride, for example, the composition of the starting gas in the PECVD method may be controlled, or that is, when the ammonia/silane ratio is high, then the resulting compound may have a high hydrogen content.

The film density of the silicon hydronitride layer in the invention may be from 1.8 to 2.7 g/m$^3$, preferably from 1.8 to 2.4 g/m$^3$. Having a film density of at most 2.7 g/m$^3$, the layer may exhibit a further enhanced moisture-absorbing effect. The preferred thickness of the silicon hydronitride layer varies, depending on the site in which the layer is used. In general, the thickness of the layer may be from 10 to 2000 nm, preferably from 50 to 1000 nm.

The silicon hydronitride layer may be formed in any method capable of forming the intended layer. As other formation methods than the PECVD method, there may be mentioned a sputtering method, a vacuum evaporation method, an ion plating method, etc. Concretely, the formation methods described in Japanese Patent 3400324, JP-A 2002-322561 and 2002-361774 are employable herein.

(Functional Layer)

The barrier laminate of the present invention may have a functional layer on the barrier laminate or in any other position. The functional layer is described in detail in JP-A 2006-289627, paragraphs 0036 to 0038. Examples of other functional layers than those are a matting agent layer, a protective layer, an antistatic layer, a smoothening layer, an adhesiveness improving layer, a light shielding layer, an antireflection layer, a hard coat layer, a stress relaxing layer, an antifogging layer, an anti-soiling layer, a printable layer, an adhesive layer, etc.

EXAMPLES

The characteristics of the invention are described more concretely with reference to the following Examples. In the following Examples, the material used, its amount and the ratio, the details of the treatment and the treatment process may be suitably modified or changed. Accordingly, the invention should not be limitatively interpreted by the Examples mentioned below.

<Formation of Film having Gas-Barrier Laminate>

Formation of Film having Gas-Barrier Laminate (1):

Using a wire bar, a composition comprising the polymerizable compounds mentioned below (14 parts by weight in total), a polymerization initiator (Ciba Speciality Chemicals, Irgacure 907, 1 part by weight) and 2-butanone (185 parts by weight) was applied onto a polyethylene naphthalate film (PEN, Teijin-DuPont's Teonex Q65FA, having a thickness of 100 μm), and cured through irradiation with UV at a dose of 0.5 J/cm$^2$ in an atmosphere of 100 ppm oxygen, thereby forming an organic polymer layer. The thickness of the organic polymer layer was 500 nm. Next, an $Al_2O_3$ layer having a thickness of 40 nm was formed on the surface of the organic polymer layer through vacuum sputtering (reactive sputtering), thereby producing a film having a gas-barrier laminate.

Composition of Polymerizable Compounds:

Composition of polymerizable compounds used in this Example is as follow:

Compound A: Kyoeisha Chemical's Light Acrylate 1,9-ND-A: 50% by mass

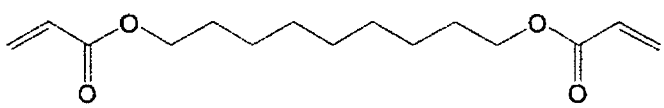

Compound B: Daicel-Cytec's TMPTA: 30% by mass

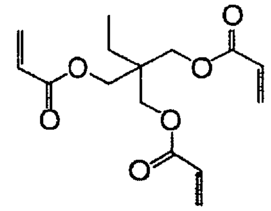

Compound C: Daicel-Cytec's IRR=214K: 10% by mass

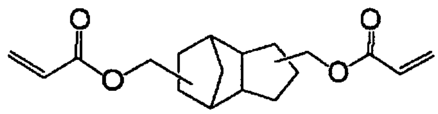

Compound D: Nippon Kayaku's Kayarad, PM-21: 10% by mass

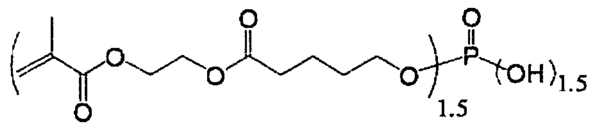

Formation of Film having Gas-Barrier Laminate (2):

In the same manner as in the production of film having gas-barrier laminate (1) above, a film having gas-barrier laminate consisting of one organic polymer layer and one inorganic layer were formed. In the same manner, one organic polymer layer and one inorganic layer were formed thereon. Accordingly, a film having gas-barrier laminate (2) was produced, alternately comprising two organic polymer layers and two inorganic layers.

Formation of Film having Gas-Barrier Laminate (3):

A film having gas-barrier laminate (3) was prepared in the same manner as in the production of film having gas-barrier laminate (2) except that the number of organic layer and the number of inorganic layer were changed to 3, respectively.

Formation of Film having Gas-Barrier Laminate (4):

Gas-barrier film was produced in the same manner as in the production of the film having gas-barrier laminate (3), for which $Al_2O_3$ in the inorganic layer was changed to $SiO_2$.

Formation of Film having Gas-Barrier Laminate (5):

Gas-barrier film was produced in the same manner as in the production of the film having gas-barrier laminate (3), for which $Al_2O_3$ in the inorganic layer was changed to $Si_3N_4$.

Formation of Film having Inorganic Layer (6):

A film having inorganic layer (6) was produced in the same manner as in the production of the film having gas-barrier laminate (1), in which the organic polymer layer was not formed and which therefore had one inorganic layer alone.

<Determination of Water Vapor Permeability>

Thus produced, the films comprising gas-barrier laminate and the comparative film were tested for the barrier property (water vapor permeability) according to the method mentioned below.

[Barrier Property]

According to the method described in SID Conference Record of the International Display Research Conference 1435-1438 (by G. NISATO, P.C.P. BOUTEN, P.J. SLIKKERVEER, et al.) (so-called calcium method), the films were analyzed for the water vapor permeability (g/m$^2$/day) thereof. In the test method, the temperature was 40°C and the relative humidity was 90%.

Table 1

| | Number of Organic Layers | Material of Inorganic Layer | Number of Inorganic Layers | Water Vapor Permeability (g/m$^2$/day) |
|---|---|---|---|---|
| Film having Gas-barrier Laminate (1) | 1 | $Al_2O_3$ | 1 | 0.0004 |
| Film having Gas-barrier Laminate (2) | 2 | $Al_2O_3$ | 2 | at most 0.0001 |
| Film having Gas-barrier Laminate (3) | 3 | $Al_2O_3$ | 3 | at most 0.0001 |
| Film having Gas-barrier Laminate (4) | 3 | $SiO_2$ | 3 | at most 0.0001 |
| Film having Gas-barrier Laminate (5) | 3 | $Si_3N_4$ | 3 | at most 0.0001 |
| Film having Inorganic Layer (6) | none | $Al_2O_3$ | 1 | 0.03 |

Example 1: Production of Sealed Solar Cell Device:

A CIGS solar cell device having the following device constitution was produced.

(Device Constitution)

Film of stainless substrate/molybdenum film/CIGS film/CdS film/ZnO film: Al film/silicon hydronitride layer/adhesive layer/gas-barrier laminate (or comparative film):

A molybdenum film of a positive electrode was deposited on a stainless substrate so as to have a film thickness of 0.8 μm thereon according to a sputtering method. A CIGS film was formed on this so as to have a thickness of 2 μm. In this Example, used were a high-purity Cu disc target (purity: 99.9999%), a high-purity In disc target (purity: 99.9999%), a high-purity Ga disc target (purity: 99.999%) and a high-purity Se disc target (purity: 99.999%). Regarding the condition for film formation, the evaporation rate from each vapor source was controlled and the maximum substrate temperature was 550°C. Next, a CdS film of an n-type semiconductor layer was deposited to have a thickness of 90 nm, according to a solution growth method; and on this, a transparent electroconductive film of a negative electrode, ZnO film:Al film was formed to have a thickness of 0.6 μm according to a high-frequency (RF) sputtering method. Finally, an upper electrode of a grid electrode, Al film was formed according to an evaporation method. The thickness of the Al film was 200 nm. According to this process, an unsealed solar cell device was produced on the substrate.

A silicon hydronitride layer was formed on the surface of the solar cell device produced in the above, according to a PECVD method. The solar cell device was set in a reaction chamber, and under reduced pressure, a starting gas material of PECVD starting gas formulation 1 mentioned below was introduced into it with applying a high-frequency power of 13.56 MHz thereinto for plasma generation to thereby form a silicon hydronitride layer. The time for film formation was so controlled that the thickness of the silicon hydronitride layer formed could be 400 nm. The formed layer was analyzed for the density thereof according to X-ray diffractiometry, and the density was 1.9 g/cm$^3$. The composition of the silicon hydronitride layer was Si: 29%, N: 23%, O: 1% and H: 47% (atomic %). The other elements than hydrogen

were quantified according to an ESCA method. Hydrogen was quantified through forward scattering spectrometry.

(PECVD Starting Gas Formulation 1)

| | |
|---|---|
| Silane | 25 sccm |
| Ammonia | 50 sccm |
| Nitrogen | 175 sccm |

Next, using a thermosetting adhesive (Epotec 310, by Daizo-Nichimori), the formed solar cell device was stuck to any of the above-produced films (1) to (6) in such a manner that the gas-barrier laminate (on the side of organic layer/inorganic layer lamination) could face the solar cell device, and the adhesive was cured by heating at 65°C for 3 hours. In that manner, sealed solar cell devices (1) to (6) were produced. A polyethylene naphthalate film alone with no gas-barrier laminate disposed thereon was stuck to the unsealed solar cell device in the same manner as herein, thereby producing a comparative solar cell device (7). The effective region of the produced solar cell device was 5 mm square, and the effective area thereof was 0.25 $cm^2$.

<Evaluation of Photoelectric Conversion Characteristic>

Irradiated with artificial sunlight of AM 1.5 and 100 $mW/cm^2$, the thus-produced solar cell devices were tested for the current-voltage characteristics thereof, using a source measure unit (SMU2400 Model, by Keithley). The test data are shown in Table 2. In this, FF means a fill factor, which is nondimensional.

Table 2

| Solar Cell Device | Sealing Material | Open Voltage (V) | Short- Circuit Current Density ($mA/cm^2$) | FF | Conversion Efficiency (%) | Remarks |
|---|---|---|---|---|---|---|
| (1) | film (1) having gas-barrier laminate | 0.55 | 25.5 | 0.64 | 9.0 | the Invention |
| (2) | film (2) having gas-barrier laminate | 0.54 | 26.4 | 0.64 | 9.3 | the Invention |
| (3) | film (3) having gas-barrier laminate | 0.52 | 26.6 | 0.66 | 9.1 | the Invention |
| (4) | film (4) having gas-barrier laminate | 0.54 | 25.3 | 0.63 | 8.6 | the Invention |
| (5) | film (5) having gas-barrier laminate | 0.53 | 26.4 | 0.68 | 9.5 | the Invention |
| (6) | film (6) having inorganic layer | 0.53 | 24.9 | 0.67 | 8.8 | the Invention |
| (7) | PEN film | 0.54 | 25.9 | 0.62 | 8.6 | Comparative Example |

Comparative Solar Cell (8)

A comparative solar cell (8) was produced in the same manner as in Example 1, for which, however, ITO was used in place of the transparent electroconductive layer ZnO:Al. In this, as the film having a gas-barrier laminate, used was the film (5) having gas-barrier laminate. The conversion efficiency in the solar cell (8) was 1.5%. From this, it is known that in the solar cell comprising indium tin oxide (ITO), the conversion efficiency is still low even though a gas-barrier laminate is provided therein.

The solar cell devices were kept in a high-temperature high-humidity room at 60°C and at a relative humidity of 90% for 500 hours, and then, while irradiated with artificial sunlight of AM 1.5 and 100 $mW/cm^2$, the devices were again tested for the current-voltage characteristics thereof. From the found data, the conversion efficiency retention was computed. The test results are shown in Table 3.

Conversion Efficiency Retention (%)
= [(Conversion Efficiency after kept under high temperature and high humidity)/(Conversion Efficiency just after device production)] × 100

Table 3

| Sample No. | Conversion Efficiency just after device production (%) | Conversion Efficiency after kept under high temperature and high humidity (%) | Conversion Efficiency Retention (%) |
|---|---|---|---|
| Solar Cell device (1) of the Invention | 9.0 | 8.0 | 89 |
| Solar Cell device (2) of the Invention | 9.3 | 9.2 | 99 |
| Solar Cell device (3) of the Invention | 9.1 | 8.9 | 98 |
| Solar Cell device (4) of the Invention | 8.6 | 8.7 | 101 |
| Solar Cell device (5) of the Invention | 9.5 | 9.4 | 100 |
| Solar Cell device (6) of the Invention | 8.8 | 6.2 | 70 |
| Solar Cell device (7) of Comparative Example | 8.6 | 5.2 | 60 |
| Solar Cell device (8) of Comparative Example | 1.5 | 1.5 | 100 |

It is known that the solar cell devices of the invention all secure a high conversion efficiency retention after kept under high temperature and high humidity and therefore have high durability. In particular, it is known that the durability of the solar cell devices (1) to (5) having at least one organic layer and at least one inorganic layer is high, and the durability of the solar cell devices (2) to (5) having plural organic layers and inorganic layers is especially high. Specifically, it is obvious that the durability under high temperature and high humidity of the zinc oxide-containing devices having a silicon hydronitride layer and a barrier laminate is high.

A solar cell device (12) of the invention and comparative solar cell devices (17) and (18) were produced like the solar cell devices (2), (7) and (8) in Example 1; in these, however, a silicon hydronitride layer was not provided. The conversion efficiency of these solar cell devices just after their production was on the same level as that of the corresponding solar cell devices (2), (7) and (8), respectively. Specifically, irrespective of the presence or absence of the silicon hydronitride layer, the solar cell devices comprising zinc oxide and comprising a gas-barrier laminate are superior to the solar cell device comprising ITO in point of the conversion efficiency. However, as is obvious from the comparison between the solar cell device (2) and the solar cell device (12) of the invention, it is confirmed that the solar cell device having a silicon hydronitride layer disposed therein has higher durability and is therefore more advantageous.

Next, the solar cell device (12) of the invention and the comparative solar cell devices (17) and (18) were kept in a high-temperature high-humidity room at 60°C and at a relative humidity of 90% for 500 hours and tested for their

conversion efficiency retention. As a result, the conversion efficiency retention in these devices was 91%, 40% and 90%, respectively. The durability of the solar cell device (17) sealed up with a PEN film was not good. As in the above, it is known that only the solar cell device (12) of the invention exhibited a high conversion efficiency and its conversion efficiency retention was high.

Example 2:

Production of Thin-Film Transistor (TFT):

A TFT device having a constitution of the invention was produced. Its schematic cross-sectional view is shown in Fig. 4.

As the substrate 41, used was an alkali-free glass sheet (Corning's Lot No. 1737). The substrate was ultrasonically washed with pure water for 15 minutes, with acetone for 15 minutes and with pure water for 15 minutes in that order. Then, using an indium tin oxide (ITO) target (indium/tin = 95/5 (by mol)) having an $SiO_2$ content of 10% by mass, an ITO thin film (thickness, 30 nm) as the gate electrode 42 was formed on it, in a mode of RF magnetron sputtering (condition: film formation temperature 43°C, sputtering gas Ar = 12 sccm, RF power 40 W, film formation pressure 0.4 Pa). ITO Of the gate electrode 42 was patterned, using a shadow mask in sputtering.

Next, the following gate-insulating film 43 was formed on the gate electrode.

A film of $SiO_2$ was formed to have a thickness of 200 nm, according to an RF magnetron sputtering vacuum evaporation method (condition: target $SiO_2$, film formation temperature 54°C, sputtering gas $Ar/O_2$ = 12/2 sccm, RF power 400 W, film formation pressure 0.4 Pa). This is the gate-insulating film 43. The gate-insulating film 43 was patterned, using a shadow mask in sputtering.

On the gate-insulating film 43, formed was the active layer 44 (thickness 50 nm), according to an RF magnetron sputtering vacuum evaporation method and using a polycrystalline sintered body having a composition of $InGaZnO_4$ as the target. The condition is as follows: The Ar flow rate was 12 sccm; the $O_2$ flow rate was 1.4 sccm; the RF power was 200 W, the pressure was 0.4 Pa. The composition of the formed layer was In/Ga/Zn = 1.0/0.95/0.56. The electroconductivity of the layer was $5.9 \times 10^{-3}$ S/cm; the carrier concentration was $1.1 \times 10^{16}/cm^3$; the hole mobility was 3.0 $cm^2/Vs$. Like in the above, $InGaZnO_4$ of the active layer was patterned, using a shadow mask in sputtering.

Next, as a source electrode and a drain electrode, ITO was vapor-deposited to have a thickness of 40 nm on the above-mentioned active layer according to an RF magnetron sputtering method (condition: film formation temperature 43°C, sputtering gas Ar = 12 sccm, RF power 40 W, film formation pressure 0.4 Pa). The source electrode and the drain electrode were patterned, using a shadow mask in sputtering. As a result of the above process, a TFT device was produced, having a reversed-staggered structure with a channel length L of 200 $\mu$m and a channel width W of 1000 $\mu$m.

On the surface of the TFT produced in the above, formed was a silicon hydronitride layer through PECVD in the same manner as in Example 1. The thickness of the formed film was 200 nm.

Next, using a thermosetting adhesive (Epotec 310, by Daizo-Nichimori), the TFT thus produced herein was stuck to the film (2) having a gas-barrier laminate produced in Example 1 or a polyethylene terephthalate film, in such a manner that the barrier laminate could face the TFT, and the adhesive was cured by heating at 65°C for 3 hours. In that manner, a TFT (2) sealed up with a film having a gas-barrier laminate, and a TFT (7) sealed up with a polyethylene naphthalate film were produced.

(Evaluation of Thin-Film Transistor Performance)

The TFT devices produced in the above were tested for the TFT transmission performance at a saturation region drain voltage Vd = 40 V (gate voltage - 20 V $\leq$ Vg $\leq$ 40 V), thereby evaluating the field effect mobility of the TFT devices. The TFT transmission performance was measured, using a semiconductor parameter analyzer 4156C (by Agilent Technologies).

The field effect mobility $\mu$ in the saturation region can be derived from the TFT transmission performance, according to the following formula:

$$\mu = (2L/W \times C_{ox}) \times (\partial Id^{1/2}/\partial Vg)$$

wherein L means the channel length; W means the channel width; $C_{ox}$ means the electrostatic capacity of the gate-insulating film, Id means the drain current; and Vg means the gate electrode.

The TFT devices were kept in a high-temperature high-humidity room at 60°C and at a relative humidity of 90% for 500 hours, and then the field effect mobility thereof was measured. From the found data, the field effect mobility

retention was computed.

$$\text{Field Effect Mobility Retention (\%)} = [(\text{Field Effect Mobility after kept under high temperature and high humidity})/(\text{Field Effect Mobility just after device production})] \times 100$$

Table 4

| TFT Device | Field Effect Mobility just after device production ($cm^2/Vs$) | Field Effect Mobility after kept under high temperature and high humidity ($cm^2/Vs$) | Field Effect Mobility Retention (%) | Remarks |
|---|---|---|---|---|
| (2) | 17 | 16 | 94 | the Invention |
| (7) | 17 | 8 | 47 | Comparative Example |

Obviously, the TFT of the invention, or that is, the zinc oxide-containing device having a silicon hydronitride layer and a barrier laminate has high durability under high-temperature high-humidity condition.

A TFT was produced in the same manner as that for the TFT (2) in Example 2, which, however, did not have a silicon hydronitride layer. This was kept in a high-temperature high-humidity room at 60°C and a relative humidity of 90% for 500 hours, and its field effect mobility retention as determined in the same manner as herein was 85%.

Specifically, it is known that the zinc oxide-containing device having a barrier laminate has high durability under high-temperature high-humidity condition than in Comparative Example, and the device having a silicon hydronitride layer has higher durability and is more advantageous.

INDUSTRIAL APPLICABILITY

The device of the invention is extremely meaningful in that it has good storage stability and is durable to long-term use.

## Claims

**1.** A sealed device having in that order:

i) a substrate;
ii) a device having a semiconducting or electroconductive layer comprising zinc and oxygen;
iii) a silicon hydronitride layer; and
iv) a gas-barrier laminate comprising

- an organic layer or region, and
- an inorganic layer or region.

**2.** The sealed device of claim 1, wherein the device on the substrate is sealed with the silicon hydronitride layer.

**3.** The sealed device of claim 2, wherein the device is further sealed with the gas-barrier laminate.

**4.** The sealed device of any of claims 1-3, wherein the silicon hydronitride layer comprises at most 50 atom-% of oxygen, relative to nitrogen in the silicon hydronitride layer.

**5.** The sealed device of any of claims 1-4, wherein the silicon hydronitride layer has a hydrogen/nitrogen atom ratio of 0.1-3.

6. The sealed device of any of claims 1-5, wherein the density of the silicon hydronitride layer is 1.8-2.7 $g_/m^3$.

7. The sealed device of any of claims 1-6, wherein the semiconductor layer or the electroconductive layer comprises zinc oxide.

8. The sealed device of any of claims 1-7, wherein the gas-barrier laminate comprises at least two organic layers and at least two inorganic layers that are alternately laminated.

9. The sealed device of any of claims 1-8, wherein the substrate is a flexible substrate.

10. The sealed device of any of claims 1-9, wherein the inorganic region or the inorganic layer comprises aluminum oxide.

11. The sealed device of any of claims 1-9, wherein the inorganic region or the inorganic layer comprises silicon oxide.

12. The sealed device of any of claims 1-11, wherein the organic region or the organic layer comprises an acrylate polymer.

13. The sealed device of any of claims 1-12, wherein the device is a solar cell.

14. The sealed device of any of claims 1-12, wherein the device is a thin-film transistor.

**Patentansprüche**

1. Abgedichtete Vorrichtung, die in dieser Reihenfolge aufweist:

    i) ein Substrat;
    ii) eine Vorrichtung, die eine halbleitende oder elektrisch leitfähige Schicht aufweist, umfassend Zink und Sauerstoff;
    iii) eine Silizium-Hydronitridschicht; und
    iv) ein Gas-Barrieren-Laminat, umfassend

        - eine(n) organische(n) Schicht oder Bereich und
        - eine(n) anorganische(n) Schicht oder Bereich.

2. Abgedichtete Vorrichtung gemäß Anspruch 1, worin die Vorrichtung auf dem Substrat mit der Silizium-Hydronitridschicht abgedichtet ist.

3. Abgedichtete Vorrichtung gemäß Anspruch 2, worin die Vorrichtung ferner mit dem Gas-Barrieren-Laminat abgedichtet ist.

4. Abgedichtete Vorrichtung gemäß irgendeinem der Ansprüche 1 bis 3, worin die Silizium-Hydronitridschicht höchstens 50 Atom% Sauerstoff umfasst, relativ zum Stickstoff in der Silizium-Hydronitridschicht.

5. Abgedichtete Vorrichtung gemäß irgendeinem der Ansprüche 1 bis 4, worin die Silizium-Hydronitridschicht ein Wasserstoff/Stickstoff-Atomverhältnis von 0,1 bis 3 aufweist.

6. Abgedichtete Vorrichtung gemäß irgendeinem der Ansprüche 1 bis 5, worin die Dichte der Silizium-Hydronitridschicht 1,8 bis 2,7 $g/m^3$ beträgt.

7. Abgedichtete Vorrichtung gemäß irgendeinem der Ansprüche 1 bis 6, worin die Halbleiterschicht oder die elektrisch leitfähige Schicht Zinkoxid umfasst.

8. Abgedichtete Vorrichtung gemäß irgendeinem der Ansprüche 1 bis 7, worin das Gas-Barrieren-Laminat mindestens zwei organische Schichten und mindestens zwei anorganische Schichten umfasst, die alternierend laminiert sind.

9. Abgedichtete Vorrichtung gemäß irgendeinem der Ansprüche 1 bis 8, worin das Substrat ein flexibles Substrat ist.

**10.** Abgedichtete Vorrichtung gemäß irgendeinem der Ansprüche 1 bis 9, worin der anorganische Bereich oder die anorganische Schicht Aluminiumoxid umfasst.

**11.** Abgedichtete Vorrichtung gemäß irgendeinem der Ansprüche 1 bis 9, worin der anorganische Bereich oder die anorganische Schicht Siliziumoxid umfasst.

**12.** Abgedichtete Vorrichtung gemäß irgendeinem der Ansprüche 1 bis 11, worin der organische Bereich oder die organische Schicht ein Acrylatpolymer umfasst.

**13.** Abgedichtete Vorrichtung gemäß irgendeinem der Ansprüche 1 bis 12, worin die Vorrichtung eine Solarzelle ist.

**14.** Abgedichtete Vorrichtung gemäß irgendeinem der Ansprüche 1 bis 12, worin die Vorrichtung ein Dünnfilmtransistor ist.

**Revendications**

**1.** Dispositif scellé présentant dans cet ordre :

i) un substrat ;
ii) un dispositif présentant une couche semiconductrice ou électroconductrice comprenant du zinc et de l'oxygène ;
iii) une couche d'hydronitrure de silicium ; et
iv) un stratifié de barrière au gaz comprenant

- une couche ou région organique, et
- une couche ou région inorganique.

**2.** Dispositif scellé selon la revendication 1, dans lequel le dispositif sur le substrat est scellé avec la couche d'hydronitrure de silicium.

**3.** Dispositif scellé selon la revendication 2, dans lequel le dispositif est de plus scellé avec le stratifié de barrière au gaz.

**4.** Dispositif scellé selon l'une quelconque des revendications 1-3, dans lequel la couche d'hydronitrure de silicium comprend au plus 50 % en atome d'oxygène, par rapport à l'azote dans la couche d'hydronitrure de silicium.

**5.** Dispositif scellé selon l'une quelconque des revendications 1-4, dans lequel la couche d'hydronitrure de silicium présente un rapport d'atome hydrogène/azote de 0,1-3.

**6.** Dispositif scellé selon l'une quelconque des revendications 1-5, dans lequel la densité de la couche d'hydroniture de silicium est de 1,8-2,7 g/$m^3$.

**7.** Dispositif scellé selon l'une quelconque des revendications 1-6, dans lequel la couche semiconductrice ou la couche électroconductrice comprend de l'oxyde de zinc.

**8.** Dispositif scellé selon l'une quelconque des revendications 1-7, dans lequel le stratifié de barrière au gaz comprend au moins deux couches organiques et au moins deux couches inorganiques qui sont stratifiées de manière alternée.

**9.** Dispositif scellé selon l'une quelconque des revendications 1-8, dans lequel le substrat est un substrat flexible.

**10.** Dispositif scellé selon l'une quelconque des revendications 1-9, dans lequel la région inorganique ou la couche inorganique comprend de l'oxyde d'aluminium.

**11.** Dispositif scellé selon l'une quelconque des revendications 1-9, dans lequel la région inorganique ou la couche inorganique comprend de l'oxyde de silicium.

**12.** Dispositif scellé selon l'une quelconque des revendications 1-11, dans lequel la région organique ou la couche organique comprend un polymère d'acrylate.

**13.** Dispositif scellé selon l'une quelconque des revendications 1-12, dans lequel le dispositif est une cellule photovoltaïque.

**14.** Dispositif scellé selon l'une quelconque des revendications 1-12, dans lequel le dispositif est un transistor à couche mince.

Fig.1

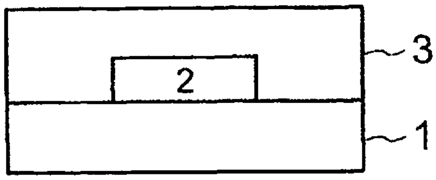


Fig.2

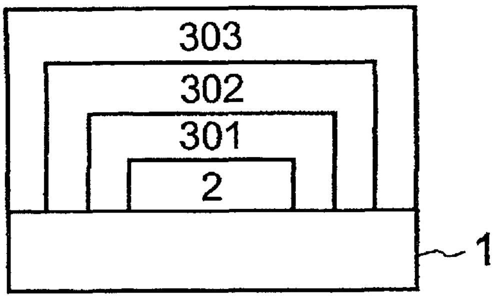


Fig.3

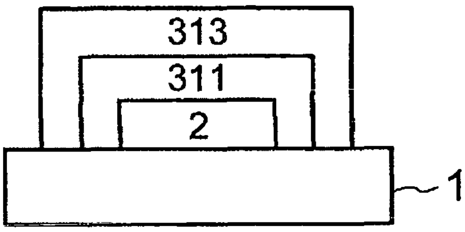


Fig.4

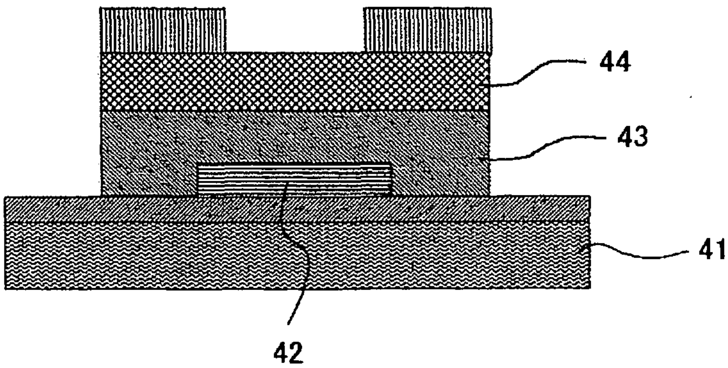

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US P6268695 A
- US 2007052025 A1
- US 6501014 B1
- JP 2007184251 A
- WO 2006110048 A1
- EP 1763086 A1
- JP 2004136466 A
- JP 2004148566 A
- JP 2005246716 A
- JP 2005262529 A
- JP 2006165529 A
- JP 3400324 B
- JP 2002322561 A
- JP 2002361774 A
- US A200446497 A
- US 200446497 A
- US P2681294 A
- JP 2000323273 A
- JP 2004025732 A
- JP 2006289627 A

### Non-patent literature cited in the description

- **G. NISATO ; P.C.P. BOUTEN ; P.J. SLIKKERVEER.** *SID Conference Record of the International Display Research Conference,* 1435-1438